# FASCICULE DE BREVET EUROPEEN

(11) **EP 1 100 201 B1**
(45) Date de publication et mention de la délivrance du brevet: **11.04.2007**
(21) Numéro de dépôt: 00403067.2
(22) Date de dépôt: 06.11.2000
(51) Int. Cl.: H03L 7/08, H03L 7/089

(54) **Boucle numérique à verrouillage de phase**
Digitaler Phasenregelkreis
Digital phase locked loop

(30) Priorité: 09.11.1999 FR 9914055
(43) Date de publication de la demande: 16.05.2001
(73) Titulaire: STMicroelectronics S.A., 92120 Montrouge (FR)
(72) Inventeur: Sirito-Olivier, Philippe, 38120 Saint-Egreve (FR)
(74) Mandataire: Brykman, Georges

(56) Documents cités:
- US-A- 4 814 726
- US-A- 5 036 216
- US-A- 5 485 125
- US-A- 5 699 387
- US-A- 5 898 328
- US-A- 5 949 264

## Description

### Domaine de l'invention

L'invention se situe dans le domaine des boucles numériques à verrouillage de phase. Elle concerne aussi un procédé de réduction du niveau de raies parasites d'un oscillateur contrôlé par une boucle de phase.

### Arrière plan technologique

Les circuits à boucle de phase sont employés par exemple chaque fois que dans un appareil électronique il existe un besoin de créer une fréquence, ayant une valeur déterminée, qui reste stable dans le temps.

Des informations sur la conception de tels circuits sont disponibles par exemple dans le livre de Ulrich L. ROHDE intitulé "Digital PLL frequency synthesizers - theory and design" publié par Prentice - Hall inc, Englewood Cliffs, NJ 07632 sous le numéro ISBN 0-13 21439-2.

L'utilité d'un tel dispositif est de générer un signal de fréquence élevée (100 MHz à plusieurs GHz) de manière précise et contrôlée.

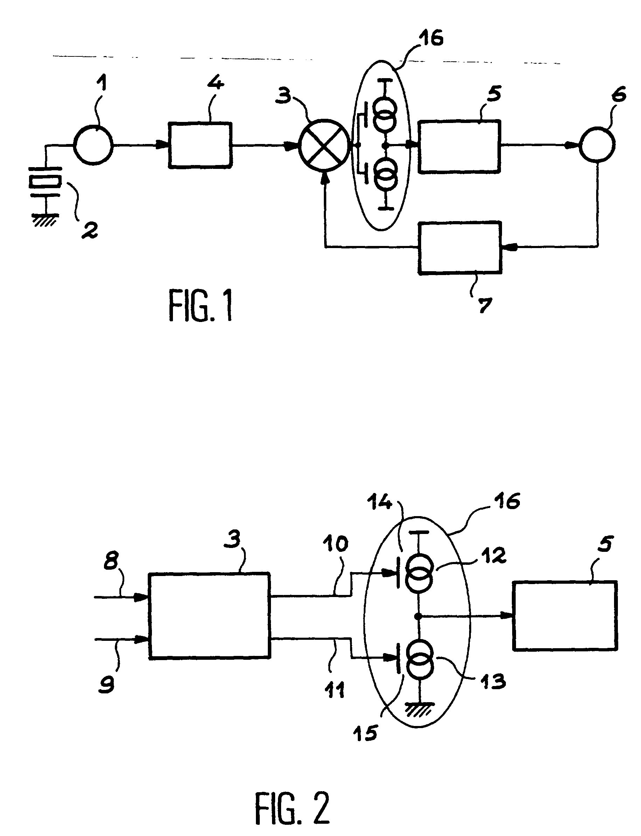

La figure 1 montre la structure classique d'une boucle (PLL) numérique.

Un signal de référence Fref, issu généralement d'un oscillateur 1 piloté par un quartz 2, est appliqué à un comparateur de phase 3 via un diviseur de fréquence 4. Le comparateur de phase 3 constitue le coeur du PLL. Il commande, via un filtre de boucle 5, un oscillateur contrôlé en tension VCO 6.

Le signal issu du VCO 6 est appliqué, généralement via un diviseur de boucle 7, au comparateur 3, ce qui constitue le rebouclage.

La sortie du dispositif peut être le signal issu du VCO 6 ou un signal intermédiaire du diviseur de boucle 7.

En jouant sur les rangs de division des diviseurs de référence et de boucle, la fréquence du signal de sortie peut être changée. La fréquence du signal de sortie est alors asservie à la fréquence de référence Fref. La pureté spectrale et la stabilité du signal de sortie sont fixées par les caractéristiques de la boucle, et par les performances du signal de référence.

Pour ce qui concerne la présente invention, on s'intéresse plus particulièrement au circuit présent en sortie du comparateur de phase 3.

Des modes de réalisation de circuit comparateur de phase sont donnés, par exemple, dans le manuel déjà cité par exemple en page 11 de ce manuel.

Le comparateur de phase fréquence dit à trois états, un état où la phase du VCO est en retard sur la phase de référence, un état où la phase du VCO est en avance sur la phase de référence et un état dit d'équilibre où ces phases sont en phases ou dans des zones de retard ou d'avance de phase pour lesquelles la boucle de phase ne peut réagir.

Le comparateur de phase fréquence à trois états PFD présente les meilleures performances de capture et de linéarité, ce qui en fait le plus utilisé des comparateurs de phase dans les circuits modernes.

L'utilisation de ce PFD se fait en lui adjoignant une pompe de charge 16 dont le rôle est de délivrer un courant fonction de la position relative des entrées Fref et Fvco du comparateur.

La figure 2 représente de façon plus détaillée le comparateur de phase 3 et un circuit de pompe de charge 16 se trouvant immédiatement en sortie du comparateur trois états 3.

Le comparateur de phase 3 comporte une première 8 et une seconde 9 entrée recevant respectivement la fréquence de référence Fref et une fréquence en provenance du VCO que l'on appelle F_{vco}. Il comporte deux sorties logiques 10, 11 respectivement dite up et down. Ces sorties 10, 11 commandent respectivement des générateurs de courant 12, 13 ayant des entrées de commande 14, 15 respectivement. Les générateurs de courant 12, 13 constituent ensemble ce qu'il est convenu d'appeler la pompe de charge 16 de l'oscillateur contrôlé en tension VCO 6. Les générateurs 12, 13 délivrent des courants en principe égaux, mais de sens opposé. En raison des tolérances sur les fabrications, un déséquilibre existe généralement entre les valeurs absolues des courants délivrés par les générateurs 12 et 13.

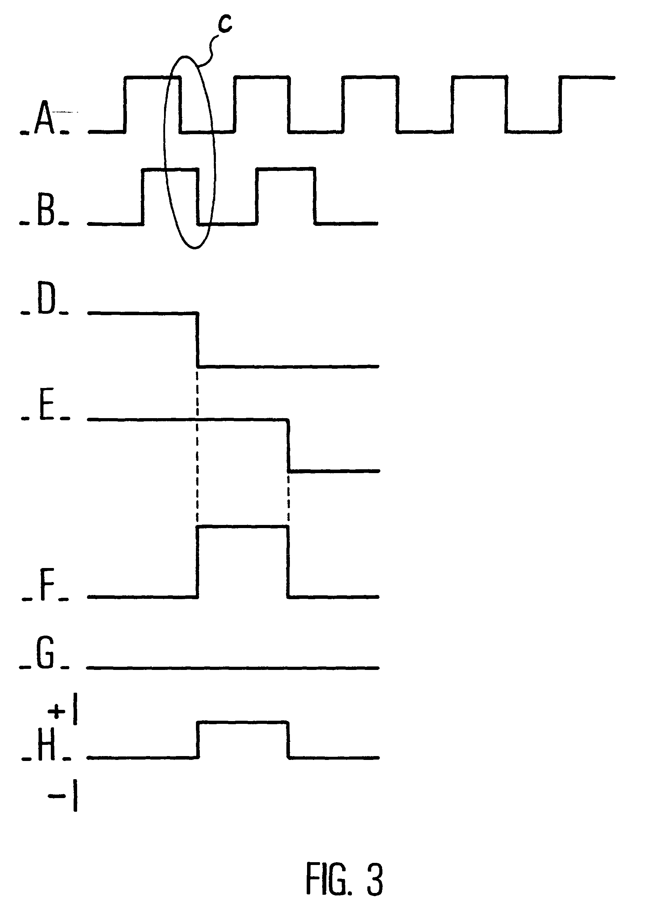

Le fonctionnement de ce circuit sera maintenant expliqué en référence aux figures 3 à 5 qui représentent différents signaux.

Les signaux représentés en ligne A et B de la figure 3 représentent la forme de signaux périodiques carrés obtenus de façon connue à partir des fréquences générées par l'oscillateur 1 de référence et le VCO 6 respectivement.

Dans l'exemple représenté lignes A et B, le front descendant du signal VCO est en retard par rapport au front descendant correspondant du signal Fref comme matérialisé dans l'encadré C.

Une vue agrandie de la situation temporelle de ces deux fronts est représentée en lignes D et E.

La valeur présente sur les sorties logiques 10 et 11 est représentée sur les lignes F et G respectivement. Le courant de charge de la pompe 16 est représenté sur la ligne H. Il peut s'agir d'un courant positif de valeur + I, d'un courant négatif de valeur - I, ou encore d'un courant nul si aucun ou les deux générateurs de courant 12 et 13 débitent.

Un front descendant de la fréquence Fref arrivant avant le front descendant de la fréquence VCO va mettre la sortie 10 up (ligne F) à une valeur logique, par exemple 1, commandant une délivrance de courant par le générateur 12.

L'arrivée du front descendant de la fréquence VCO (ligne E) va remettre la sortie logique 10 du comparateur 3 à un niveau logique, par exemple O, commandant la fermeture du générateur 12.

Le générateur 12 va ainsi charger la pompe pendant une durée égale au retard de phase entre Fvco et Fref. Cette charge a pour effet de ramener à O le retard de phase.

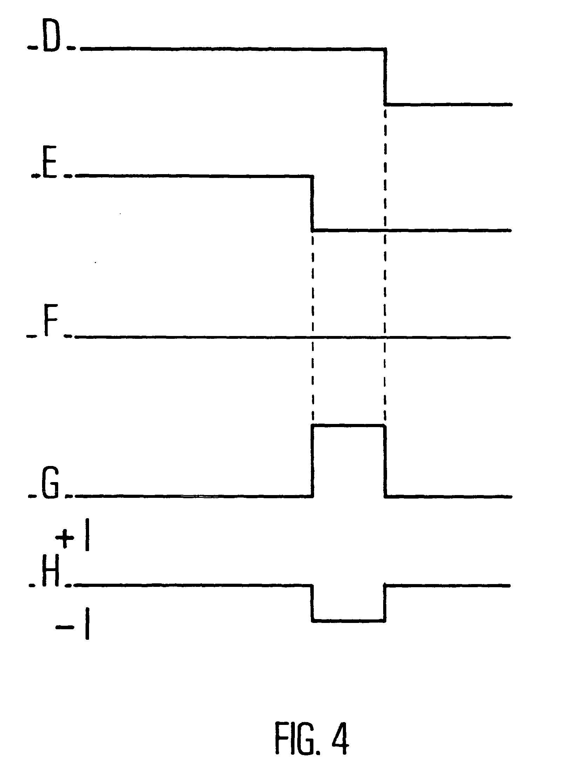

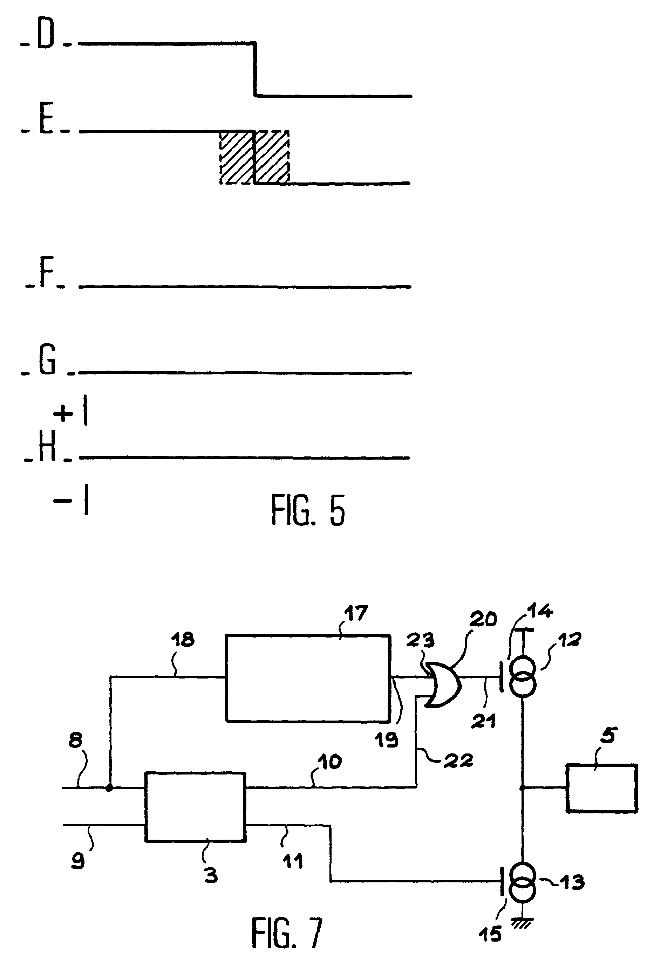

Il va être examiné maintenant de façon plus rapide en référence aux figures 4 et 5, ce qui se passe lorsque la fréquence Fvco est en avance, respectivement, en phase par rapport à la fréquence Fref.

En figure 4 le front descendant du signal Fvco représenté ligne E arrive avant le front descendant du signal Fref représenté en D. Dans ces conditions, le fonctionnement du comparateur 3 est tel que le front descendant du signal Fvco, va provoquer un changement d'une valeur logique présente en sortie 11 (down) (ligne G) du comparateur 3 cette valeur s'établissant par exemple à 1. Cette sortie va actionner la commande 15 du générateur 13. Un courant de sens opposé à celui du cas précédent, commenté en liaison avec la figure 3 va être débité par la pompe de charge 16. L'arrivée ultérieure du front descendant du signal Fref va provoquer le retour de la valeur logique présente en sortie 11 (down) du comparateur 3 à la valeur logique précédente, par exemple O, ligne G de la figure 4, et donc l'arrêt du débit du générateur 13, ligne H.

Sur la figure 5, les signaux Fref et Fvco, lignes D et E sont en phase. Dans ces conditions, les valeurs logiques présentes sur les sorties 10 et 11, lignes F et G, ne changent pas. Le courant I, ligne H est nul.

Le fonctionnement qui vient d'être décrit en liaison avec les figures 3 à 5 ne fait pas mention des temps de réaction, d'une part, du comparateur de phase 3 que l'on va appeler Tpfd et, d'autre part, des générateurs de courant que l'on va appeler Tcp.

Du fait de ces temps de réaction, il y a des zones de retard ou d'avance de phase, proches de la zone dite d'équilibre représentée figure 5 où les phases Fref et Fvco sont en phase, dans lesquelles le comparateur 3 et la pompe 16 n'ont pas le temps de réagir.

Il a été représenté figure 5, le cas où le retard du front descendants du signal Fvco est peu en retard ou peu en avance sur le front descendant du signal Fref et se situe par exemple dans la zone hachurée représentée en E figure 5. Cette zone hachurée de la figure 5 correspond au double du temps minimum nécessaire pour mettre en débit le générateur de courant 12 ou 13.

A l'intérieur de l'intervalle de temps représenté par la zone hachurée, la pompe de charge 16 n'a pas encore réagit à l'ordre de débiter lorsqu'elle reçoit l'ordre de ne plus débiter.

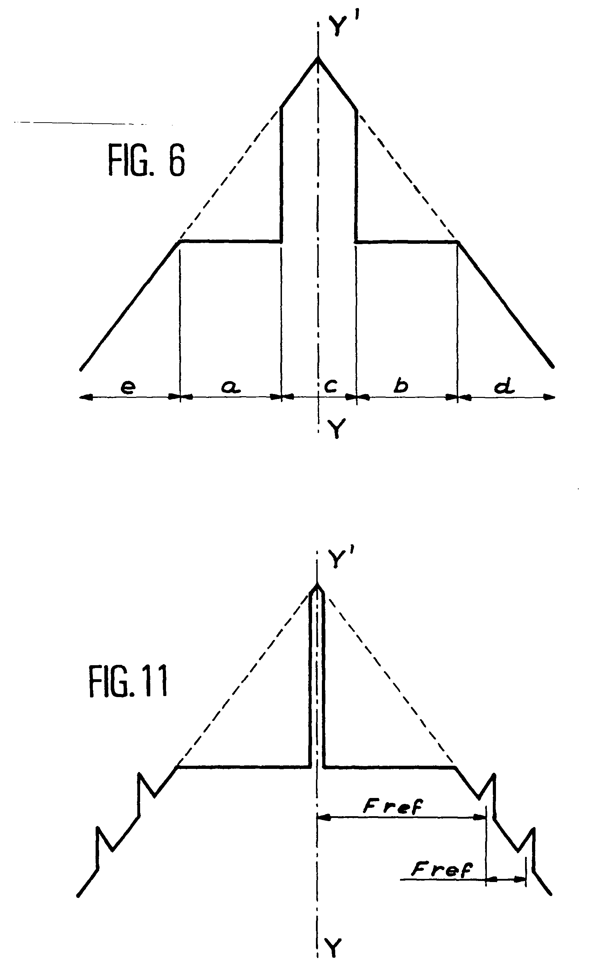

Ainsi, en ce qui concerne le contrôle exercé sur la fréquence Fvco par la boucle de phase, on obtient le résultat illustré par la courbe représentée figure 6.

Cette courbe représente la puissance de sortie en ordonnée par rapport à la fréquence en abscisse.

Cette courbe présente deux zones de palier sensiblement symétriques l'une de l'autre par rapport à un axe YY' correspondant à la valeur F_{vco}.

Une plage de fréquences marquées C pour laquelle l'axe YY' est un axe de symétrie correspond à une zone où, du fait des temps de réaction Tpfd et Tcp, on n'exerce en fait aucun contrôle sur la fréquence de sortie Fvco. Des zones de fréquences repérées a et b sur la figure 6 correspondent aux zones où du fait de la boucle de contrôle de phase, le fonctionnement du VCO sera asservi de façon stable, des zones d et e placées de façon sensiblement symétrique, l'une par rapport à l'autre, correspondent de nouveau à des plages de fréquence où la régulation ne s'exerce plus.

Dans les zones non contrôlées c et d, e, la puissance de sortie est réglée par les caractéristiques propres de l'oscillateur VC06.

On voit ainsi, que le fonctionnement de la boucle qui vient d'être décrit conduit à un fort bruit de phase dans la zone c autour de la fréquence centrale V_{vco}. Cela constitue un défaut majeur dans beaucoup d'applications.

Une solution connue pour remédier à ce défaut consiste à réinjecter de façon systématique une impulsion de courant de durée prédéterminée déclenchée par le front descendant de Fref.

La réinjection se fait sur la voie la plus lente déclenchée par Fref et la durée est fixée par conception pour assurer une impulsion de courant quelles que soient les conditions d'utilisation de la boucle de phase.

Le document US-A-5699387 décrit une boucle à verrouillage de phase dans laquelle la durée de réinjection de charge est fixée par un multivibrateur monostable ou une ligne à retard.

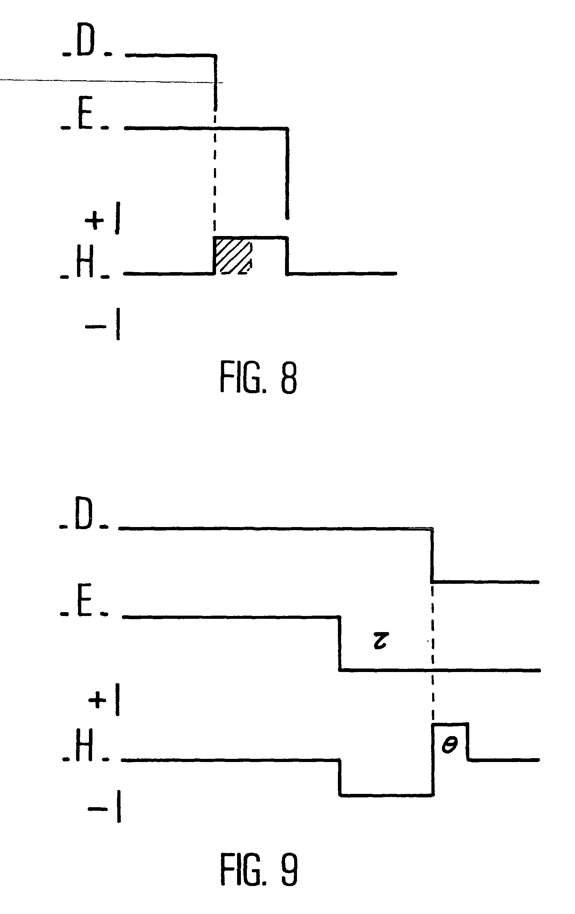

Un schéma représentant un exemple de circuit employé pour la réinjection, est représenté figure 7.

Par rapport au circuit représenté en liaison avec la figure 2, le circuit de réinjection connu destiné à éviter la zone c de non contrôle comporte un circuit de réinjection de charge 17 sous forme d'un générateur 17 d'une impulsion de durée prédéterminée.

Une entrée 18 de ce générateur 17 reçoit Fref, et une sortie 19 portant l'impulsion de sortie, alimente une première entrée 23 d'une porte OU 20. Une seconde entrée 22 de cette porte reçoit la sortie 10 (up) du comparateur 3. Une sortie 21 de la porte OU 20 commande le générateur de courant 12.

Ainsi, le générateur de courant 12 est commandé en débit pour au minimum la durée θ de l'impulsion fournie par le générateur d'impulsion 17.

Le fonctionnement de ce circuit de réinjection va maintenant être expliqué en relation avec les figures 8-10. Ces figures reprennent les mêmes annotations que celles des figures 3-5.

La figure 8 représente le cas où le retard de phase du signal Fvco est plus grand que la durée θ, représentée par une zone hachurée ligne H, de l'impulsion fournie par le générateur d'impulsion 17. Dans ce cas, le générateur de courant 12 va être commandé en débit par les deux entrées de la porte OU 20. Le temps de débit du générateur 12 dû à l'impulsion du générateur 17 est inférieur au temps de débit nécessaire pour revenir en phase, le fonctionnement est identique à celui décrit en liaison avec la figure 3. L'impulsion de durée θ ne change rien.

Dans le cas représenté figure 9 où la fréquence F_{vco} est en avance de phase d'une durée δ par rapport à Vref, on va avoir un fonctionnement identique à celui décrit en liaison avec la figure 4, avec déclenchement d'un courant de décharge du générateur 13 pendant la durée du déphasage. Cependant, l'arrivée du front descendant Fref va déclencher le générateur d'impulsion 17, ce qui va provoquer un courant de charge pendant la durée θ de l'impulsion, la boucle de phase va fonctionner de telle sorte que la somme moyenne du courant négatif et du courant positif recentre la boucle pour obtenir la fréquence F_{vco}.

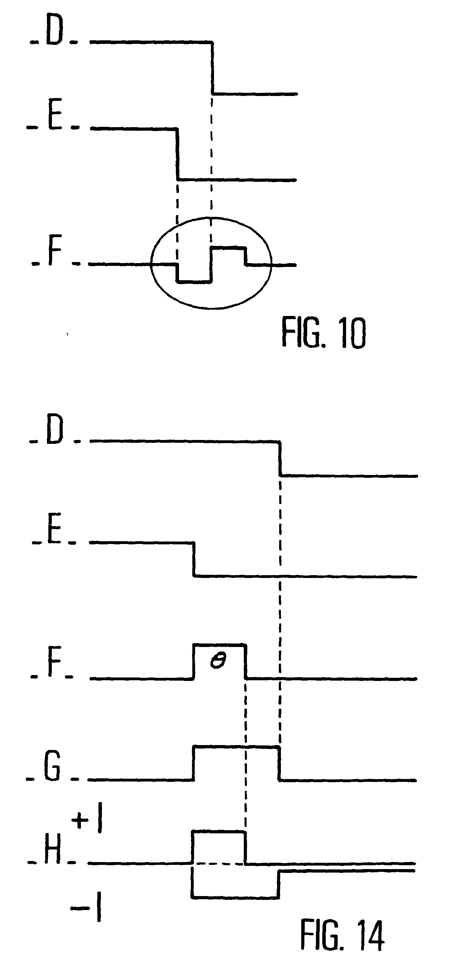

Lorsqu'on est dans la zone d'équilibre comme représenté figure 10, le courant est présent de façon alternative dans les générateurs 12 et 13 en sorte que l'on a une oscillation à la fréquence Fref.

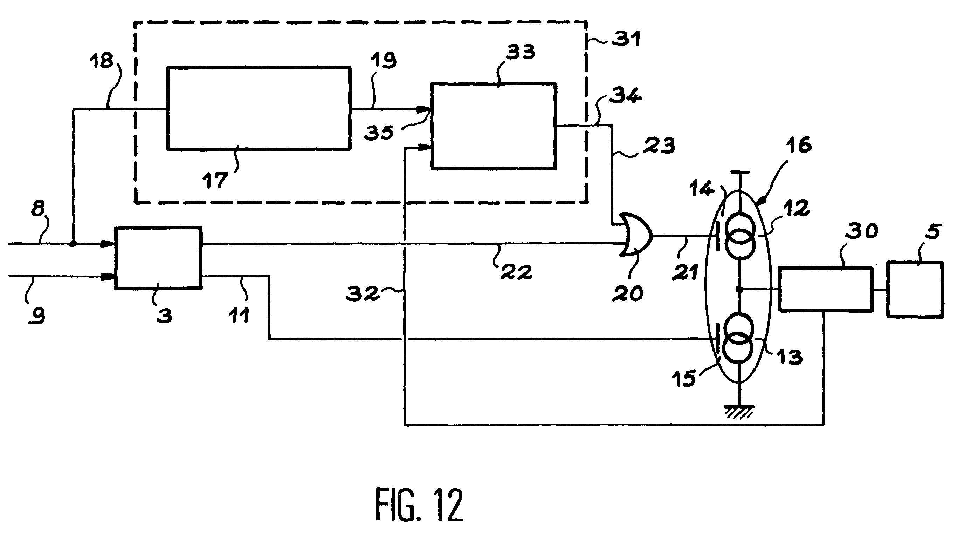

Le spectre a alors l'allure représentée figure 11. On a un pic de puissance à la fréquence Fvco, mais de plus, des pics répétés à des intervalles fréquenciels séparés par la valeur de la fréquence Fref.

Ces pics sont gênants car, par exemple, ils parasitent les canaux adjacents.

### Brève description de l'invention

L'inventeur a noté que les pics parasites sont séparés l'un de l'autre par des intervalles égaux à la valeur de la fréquence Fref, et ont une amplitude qui est croissante avec la durée de charge. L'invention consiste donc à réduire au maximum la durée de charge et donc l'amplitude de la variation de la charge qui est proportionnelle à la durée θ de l'impulsion générée par le générateur 17. On réduit ainsi, l'amplitude des pics parasites à la fréquence Fref. La durée θ de l'impulsion du générateur 17 selon l'art antérieur représenté figure 7 doit être supérieure au temps de réaction T_{PFD} du comparateur de phase 3 augmenté du temps de réaction T_{CP} du générateur de courant 12 ou 13.

Pour obtenir ce résultat quelles que soient les conditions de fonctionnement, on détermine dans les conditions du laboratoire sur quelques échantillons, une valeur supérieure de ce temps de réaction. Ensuite, pour être sûr que la durée θ reste supérieure au temps de réaction dans les conditions les plus défavorables - température, composants aux limites extrêmes des tolérances - variation des tensions d'alimentation - on multiplie le temps minimum déterminé par un facteur compris entre 5 et 10. Il en résulte que dans la plupart des cas, il est possible de réduire le temps θ et donc de diminuer l'intensité des pics parasites à la fréquence Fref.

Le temps de réaction de la boucle de phase est comme il a été expliqué plus haut, le temps qui s'écoule entre l'arrivée d'un ordre de charge et le moment où le générateur de courant de charge débite avec un niveau de courant significatif. On va donc mettre en place un détecteur du courant débité par le générateur de courant de charge, ledit détecteur changeant de niveau logique lorsque la valeur du courant généré par le générateur de courant devient supérieure à une valeur seuil et on va utiliser le changement de ce niveau logique pour changer le niveau logique en sortie du générateur d'impulsion.

Ainsi, malgré les temps de transit additionnels dus aux temps de réaction du détecteur et d'éventuels circuits additionnels on obtiendra une durée θ d'impulsion additionnelle quasiment égale au temps de réaction de la boucle

En résumé l'invention est relative à une boucle de verrouillage de phase d'un oscillateur commandé en tension, la boucle comportant un comparateur de phase recevant en entrée une fréquence de référence et une fréquence en provenance de l'oscillateur, et délivrant des valeurs logiques pour commander une pompe de charge, un circuit de réinjection de charge recevant l'une des entrées du comparateur et délivrant une valeur logique pour commander la pompe de charge, boucle caractérisée en ce qu'elle comporte en outre, un détecteur d'une valeur de seuil d'un courant représentatif du courant délivré par la pompe de charge, une sortie logique du détecteur étant appliquée en retour au circuit de réinjection de charge de façon à limiter la durée de réinjection de charge.

Le détecteur de courant pourra être couplé soit au générateur de courant inclus effectivement dans la pompe de charge, soit à un générateur additionnel identique au générateur de courant inclus dans la pompe.

La solution avec générateur additionnel présente l'inconvénient en raison des tolérances de fabrication d'avoir un seuil de déclenchement qui peut être légèrement décalé dans le temps par rapport au seuil de déclenchement du générateur inclus dans la pompe. Pour remédier à cet inconvénient, on pourra fixer le seuil de la valeur de courant déclenchant le changement de niveau logique du détecteur à une valeur légèrement supérieure à celle que l'on aurait retenu pour le générateur de la pompe. L'avantage du générateur additionnel est que la présence du détecteur et du générateur additionnel n'apporte aucune perturbation au fonctionnement de la pompe de charge.

Dans un mode particulièrement avantageux de réalisation, l'entrée du circuit de réinjection de charge est couplée non pas à l'entrée du comparateur recevant la fréquence de référence, mais à l'entrée du comparateur recevant la fréquence construite à partir de la fréquence en sortie de l'oscillateur.

Ce mode de réalisation présente l'avantage de diminuer encore la valeur du courant moyen de charge en sorte que la hauteur des pics parasites séparés entre eux de la valeur de la fréquence Fref. s'en trouve diminuée.

L'invention est également relative à un procédé tel que défini dans la revendication 3, dans lequel on limite la durée de réinjection, non pas en fonction d'un temps de réaction prédéterminé de la boucle de phase mais en limitant la durée de réinjection grâce à la détection d'une valeur de seuil de courant représentatif du courant délivré par la pompe de charge et en appliquant, en retour, une sortie logique du détecteur au circuit de réinjection de charge.

### Brève description des dessins

Un exemple détaillé de réalisation, un mode préféré de réalisation comportant une variante seront maintenant décrits en regard des dessins annexés dans lesquels :
- la figure 1 représente une boucle de verrouillage de phase d'un oscillateur commandé en tension ;
- la figure 2 représente de façon détaillée un comparateur de phase et sa pompe de charge ;
- les figures 3, 4 et 5 représentent chacune l'évolution dans le temps de signaux ;
- la figure 6 représente le spectre de fréquence en sortie du VCO lorsque la boucle de phase ne comporte pas de réinjecteur de charge ;
- la figure 7 représente de façon détaillée le comparateur de phase, sa pompe de charge et un circuit de réinjection de charge ;
- les figures 8 à 10 représentent chacune l'évolution dans le temps de signaux ;
- la figure 11 représente le spectre de fréquence en sortie de l'oscillateur contrôlé en tension lorsque la boucle de phase comporte un réinjecteur de charge.

Les figures 1 à 11 ont déjà été commentées et sont représentatives de l'art antérieur ou illustrent le fonctionnement de boucles de phase fonctionnant selon l'art antérieur.
- la figure 12 représente un premier mode de réalisation d'une partie d'une boucle de phase comportant selon l'invention un limiteur du temps de réinjection de charge ;

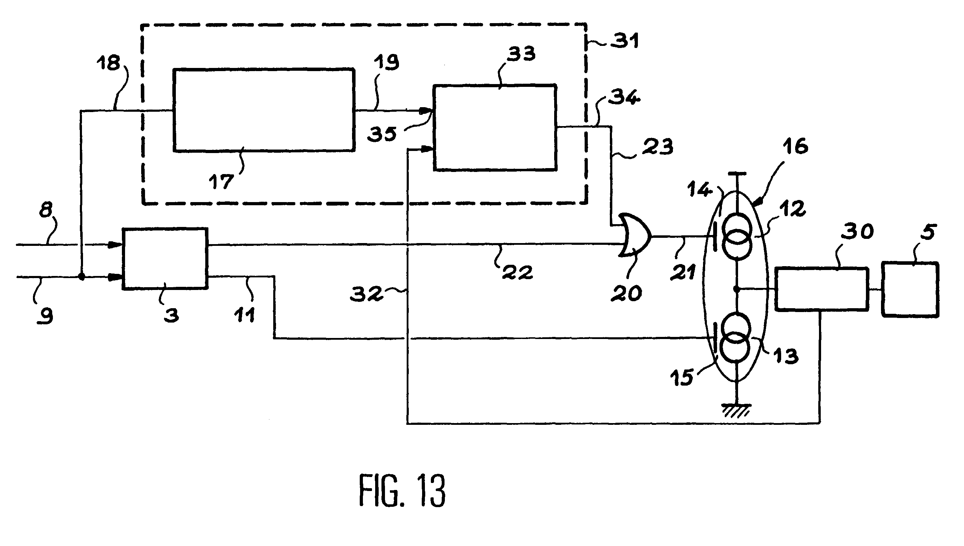

- la figure 13 représente un mode préféré de réalisation d'une partie de boucle de verrouillage de phase comportant un limiteur de temps de réinjection selon l'invention ;

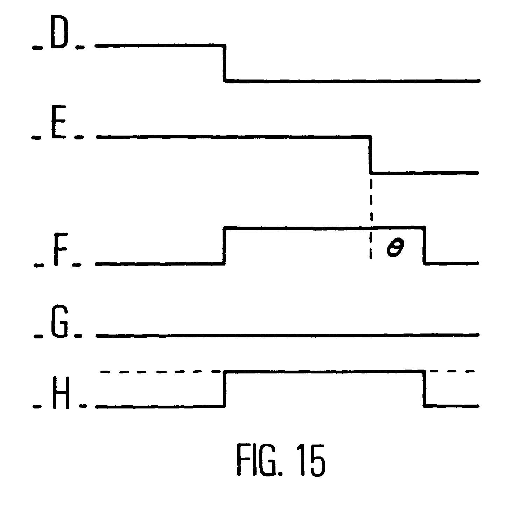

- les figures 14 à 16 représentent chacune l'évolution dans le temps de signaux ;

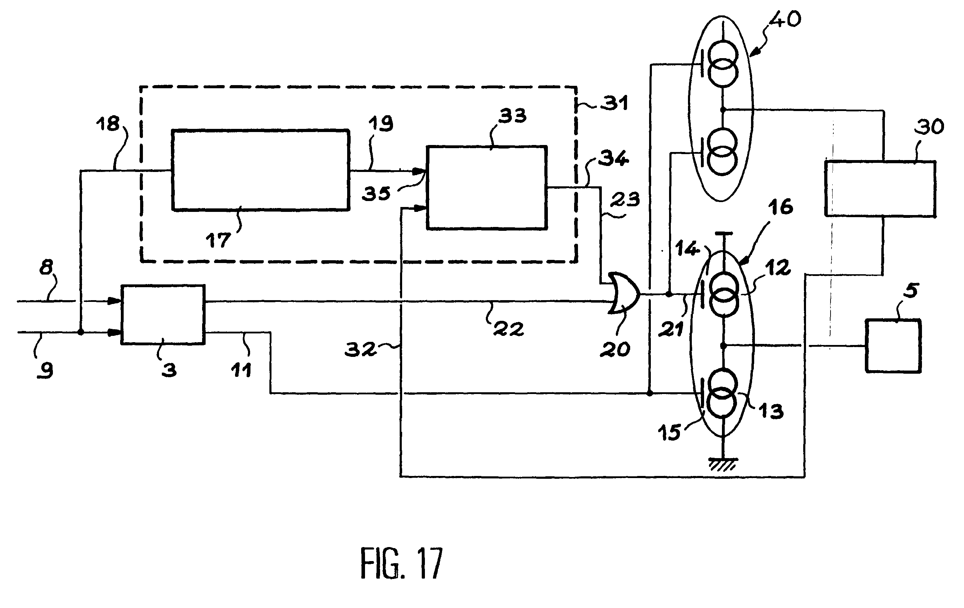

- la figure 17 représente une variante de réalisation du circuit représenté figure 12 ou du circuit représenté figure 13.

La figure 12 représente un premier exemple de circuit comportant des moyens de limitation de la durée de réinjection de charge conformément à l'invention.

Pour la description des circuits conformes à l'invention, les éléments ayant même fonction que ceux décrits en liaison avec l'art antérieur connu porteront le même numéro de référence. Ces éléments ne seront pas nécessairement commentés à nouveau dans la description qui va suivre.

Par rapport au circuit de l'art antérieur décrit en relation avec la figure 7, le circuit selon l'invention comporte de plus un détecteur 30 de courant recevant le courant de charge délivré par la pompe de charge 16. Par ailleurs, un circuit de réinjection de charge 31 comporte une entrée 32 destinée à limiter la durée de l'impulsion de réinjection de charge.

Sur la figure 12, le circuit 31 de réinjection de charge comporte un générateur 17 d'une impulsion de longueur prédéterminée θ, comme dans l'art antérieur. Au lieu d'alimenter directement la porte OU 20, la sortie 19 du générateur 17 alimente une première entrée 35 d'un circuit logique 33. Une seconde entrée de ce circuit logique 33 est constituée par l'entrée 32 portant la valeur logique en sortie du détecteur 30. Une sortie 34 du circuit logique 33 constitue la sortie du circuit de réinjection de charge 31. Cette sortie 34 est couplée à la première entrée 23 de la porte OU 20.

Le fonctionnement du circuit logique 33 est le suivant : lorsque la première entrée 35 reçoit la valeur logique, par exemple 1, présente en sortie 19 du générateur d'impulsion 17, la sortie 34 du circuit 33 prend une valeur logique, par exemple 1, commandant le débit du générateur de courant 12 de la pompe 16. Après un temps de réaction, le générateur 12 va débiter. Le débit du générateur 12 va être détecté par le détecteur 30. Sous l'effet de cette détection, la valeur logique en sortie du détecteur 30, va changer et se mettre par exemple à 1. Il en résulte que la valeur logique à l'entrée 32 du circuit logique 33 va changer également. Le circuit 33 est conçu de telle sorte que dans ce cas la sortie 34 de ce circuit reprend de façon stable la valeur logique, par exemple O, qui commande un arrêt du générateur 12. Ainsi, la durée θ de l'impulsion en sortie du circuit de réinjection 31, tel que modifié par l'invention, est limitée strictement au temps nécessaire pour mettre en route le générateur de courant 12 et au temps pour détecter cette mise en route.

Le fonctionnement du circuit représenté figure 12 est identique à celui du circuit représenté figure 7 en liaison avec les figures 8 à 10, mais du fait des moyens de limitation de la durée de l'impulsion de réinjection délivrée par le circuit de réinjection 31, l'amplitude de variation du niveau de charge dû à la pompe de charge 16 est limitée.

De ce fait, l'amplitude des pics parasites espacés de Fref est limitée à une valeur inférieure. Ce spectre en sortie se présente comme représenté figure 11, mais avec des pics parasites de niveau plus bas.

Un mode préféré de réalisation de la partie de boucle autour du comparateur de phase 3 est représenté figure 13. Ce mode de réalisation est identique à celui représenté figure 12 à l'exception de l'entrée du générateur d'impulsion 17. Selon ce mode de réalisation, l'entrée 18 du générateur d'impulsion 17 reçoit non pas le signal Fref mais le signal F_{vco}.

Dans ces conditions, le fonctionnement est celui qui va être décrit ci-après en liaison avec les figures 14 à 16.

Pour ces figures, on reprend les mêmes désignations que pour les figures 3 à 5.

Sur la figure 14, le signal Fref ligne D est en retard sur le signal F_{vco} ligne E.

A l'arrivée du front descendant de F_{vco}, selon cette variante de l'invention, l'entrée 18 du générateur d'impulsion 31 reçoit un signal logique qui déclenche une sortie ayant une valeur logique déclenchant le courant du générateur de courant 12 pour une durée θ correspondant à la durée de l'impulsion du circuit de réinjection 31.

Cela est représenté figure 14 par la ligne F représentant la valeur de commande du générateur up 12 dont la commande est par exemple égale à 1 pendant la durée θ commençant avec le front descendant de F_{vco} représenté ligne E.

Parallèlement, le front descendant du signal VCO va rendre positive la sortie 11 (down) du comparateur 3. Cette sortie représentée ligne G va rester positive jusqu'à l'arrivée du front descendant du signal Fref. Cette sortie positive commande le débit du courant du générateur 13 de courant.

Le courant représenté ligne H débité par la pompe de courant 16 est la somme algébrique des courants opposés débités par les générateurs 12 et 13.

On voit que pendant la durée θ à partir du front descendant de F_{vco}. Cette valeur est nulle (ligne pointillée) puis égale à -I pendant une durée égale au temps séparant les fronts descendants de F_{vco} et Fref, diminuée du temps θ de la durée de l'impulsion 31.

On a représenté sur la figure 15, le fonctionnement du dispositif représenté figure 13 lorsque le signal F_{vco} (ligne E)est en retard de phase par rapport au signal Fref (ligne D).

L'arrivée du front descendant de Fref déclenche le passage à 1 de la sortie 10 (up) du comparateur 3 (ligne F). La commande du générateur 12 est positive et le reste (ligne F) jusqu'à l'arrivée du front descendant du signal F_{vco}. A l'arrivée de ce front la sortie 10 revient à 0, ce qui est représenté par un pointillé ligne F. Cependant, l'arrivée du front descendant du signal F_{vco} déclenche pour une durée θ l'impulsion du générateur 31. Il en résulte que l'autre entrée 23 de la porte OU 20 devient positive au moment où l'entrée 22 revient à 0. dans ces conditions, la sortie 21 de la porte OU 20 reste à 1 et le générateur (up) 12 continue à débiter.

La sortie 11 représentée en ligne G (down) du comparateur 3 reste elle à 0. Il en résulte que le générateur 13 ne débite pas.

Dans ces conditions, la valeur du courant débité par la pompe 16, représentée ligne H, est égale à + I pendant une durée égale à la durée séparant les fronts descendants des signaux Fref et F_{vco} augmentée de la durée θ de l'impulsion délivrée par le générateur d'impulsion 31.

Il convient de remarquer que dans le cas des figures 14 et 15 les écarts de phase entre Fref et F_{vco} sont supérieurs à la durée θ de l'impulsion de réinjection du circuit de réinjection 31. On a donc négligé les régimes transitoires. Ces valeurs d'écart supérieures à la durée de l'impulsion de réinjection correspondant à un déséquilibre de la pompe de charge. On voit qu'en cas de déséquilibre la valeur moyenne de la variation de charge qui est égale à la valeur du courant I débité par la pompe de charge multipliée par le temps de débit est inchangée par rapport à l'art antérieur car dans un cas (figure 14) la durée de débit est diminuée de la durée θ et dans un autre cas (figure 15) cette durée de débit est augmentée de θ.

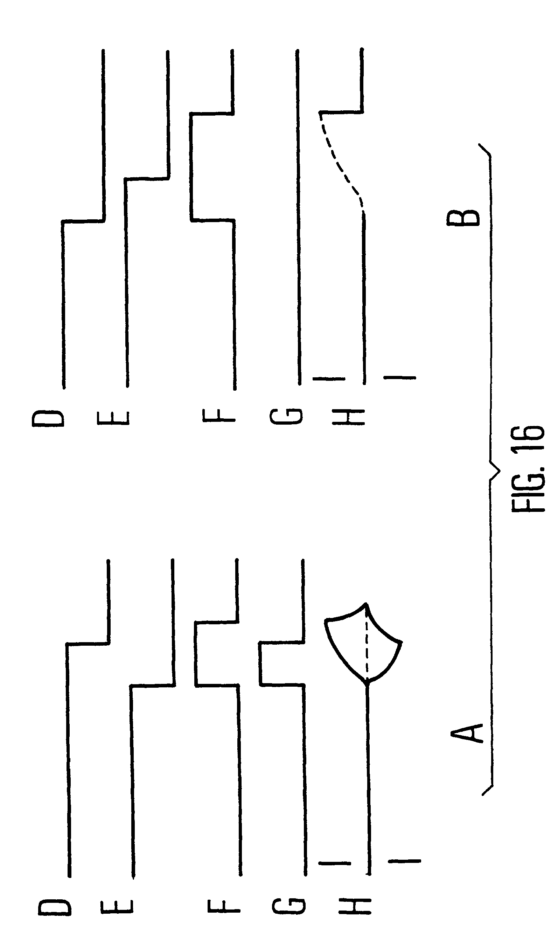

Par contre, en cas d'équilibre de la pompe de charge, c'est-à-dire lorsque le déphasage entre Fref et F_{vco} est inférieur à la durée θ les régimes transitoires ne sont plus à négliger. Les cas correspondants aux figures 14 et 15 mais avec des déphasages inférieurs à la durée de l'impulsion de réinjection ont été représentés figure 16 en parties a et b respectivement.

On voit en ligne H que le courant I de la pompe 16 reste nul ou quasi nul. Dans ces conditions, l'amplitude des raies latérales (figures 6 et 11) décalées l'une par rapport à l'autre de Fref ou de multiples de Fref est fortement diminuée.

Les résultats suivants ont été obtenus dans trois cas ci-après :

Il est précisé que ces résultats ont été obtenus pour un gain de VCO précis, une valeur de courant I précise un filtre de boucle précis, un diviseur 7 précis et une valeur de Fref précise. Il en résulte que les améliorations constatées ne sont pas directement transposables quantitativement à d'autres circuits présentant des valeurs différentes. L'application de l'invention devrait cependant apporter des améliorations.
1) Circuit sans réinjection tel que représenté figure 2 (art antérieur sans réinjection).
   Dans ce cas, l'amplitude des raies de modulation espacées de Fref est limitée par les fuites de la pompe de charge. Par exemple, pour une fuite (cas courant) d'un nano-ampère, la première raie est par rapport à la raie centrale F_{vco} recherchée à -87,5 dB. Cependant, comme signalé plus haut, du fait de l'absence de contrôle immédiatement autour de la fréquence F_{vco} il y a un fort bruit de phase autour de F_{vco}, figure 6.
2) réinjection sur up déclenché par un front descendant de Fref pour une durée fixe de réinjection de 20 nanosecondes correspondant à 5 fois le temps minimum de réinjection (art antérieur avec réinjection, représenté figure 7).
   La première raie est à -68 dBc donc à un niveau plus haut que dans le cas précédent. Par contre, le bruit de phase immédiatement autour de F_{vco} est fortement diminuée.
3) circuit selon le premier mode de réalisation de l'invention avec limiteur de la durée de réinjection l'injection étant réalisé sur un front descendant de la fréquence Fref.
   Sans fuite de la pompe de charge, la première raie est à - 96 dBc.
   Avec une fuite de la pompe de charge de 1 nano-ampère, la première raie est à - 85,7 dBc.
4) circuit selon le deuxième mode de réalisation de l'invention avec limiteur de la durée de réinjection, l'injection étant réalisée sur un front descendant de F_{vco} ;
   - avec une fuite de la pompe de 1 nano-ampère et un déséquilibre de 20 % entre les courants débités par les générateurs 12 et 13, la première raie est à - 85,7 dBc ;
   - avec une fuite de la pompe de 1 nano-ampère et un déséquilibre entre les courants débités par les générateurs 12 et 13 de 50 %, la première raie est à - 85,6 dBc.

Ainsi, dans le mode préféré de réalisation de l'invention, avec des valeurs courantes (1 nano-ampère) de courant de fuite et un déséquilibre de 20 % entre les courants débités par les deux générateurs 12, 13 de la pompe de charge 16, le niveau de la première raie parasite est à 18 dB en dessous des circuits de réinjection selon l'art antérieur.

Un mode de réalisation de l'invention avec générateur de courant auxiliaire pour la détection est représenté figure 17. Cette variante de réalisation est présentée figure 17 comme une variante du circuit représenté figure 13. Elle est applicable exactement dans les mêmes conditions au circuit représenté figure 12.

Selon cette variante le circuit comprend une pompe de charge additionnelle 40. Cette pompe de charge additionnelle reçoit la sortie de la porte OU 21 et la sortie 11 du comparateur 3. Le détecteur 30 reçoit le courant en sortie de la pompe additionnelle 40. Ce mode de réalisation, comme signalé plus haut, n'apporte aucune perturbation au fonctionnement normal de la boucle de phase.

Dans les explications et descriptions ci-dessus il a été implicitement supposé que la pente de contrôle du circuit oscillant 6 était positive, une augmentation de tension de contrôle correspondant à une augmentation de la valeur de fréquence de sortie.

L'invention est applicable également aux oscillateurs à pente de contrôle négative.

Les modifications de circuits par rapport aux circuits effectivement décrits sont à la portée de l'homme du métier.

## Revendications

1. Boucle de verrouillage de phase d'un oscillateur (6) commandé en tension, la boucle comportant un comparateur (3) de phase recevant en entrée (8,9) une fréquence de référence et une fréquence en provenance de l'oscillateur (6), et délivrant des valeurs logiques pour commander une pompe (16) de charge, un circuit (31) de réinjection de charge recevant l'une des entrées (8,9) du comparateur (3) et délivrant une valeur logique pour commander la pompe de charge (16), boucle **caractérisée en ce qu'**elle comporte en outre, un détecteur (30) d'une valeur de seuil d'un courant représentatif du courant délivré par la pompe de charge (16), une sortie logique du détecteur (30) étant appliquée en retour au circuit (31) de réinjection de charge de façon à limiter la durée de réinjection de charge.

2. Boucle selon la revendication 1, **caractérisé en ce que** le circuit (31) de réinjection de charge comporte :
- un générateur d'impulsion (17) ayant une entrée 18, cette entrée (18) constituant l'entrée (18) du circuit (31) de réinjection et une sortie (19) ;
- un circuit logique (33) ayant deux entrées (19,32) et une sortie (34) l'une des entrées (19) dudit circuit logique (33) étant couplée à la sortie (19) du générateur (17) d'impulsion, l'autre entrée (32) étant couplée à la sortie (34) dudit circuit logique (33) constituant la sortie (34) du circuit de réinjection (31).

3. Procédé de réduction d'un niveau de raies parasites délivrées par un oscillateur (6) commandé en tension et contrôlé par une boucle de phase comportant un comparateur (3) de phase recevant en entrée (8,9) une fréquence de référence et une fréquence en provenance de l'oscillateur (6), et délivrant des valeurs logiques pour commander une pompe (16) de charge, un circuit (31) de réinjection de charge recevant l'une des entrées (8,9) du comparateur (3) et délivrant une valeur logique pour commander la pompe de charge (16), procédé **caractérisé en ce qu'**on limite la durée de réinjection en détectant dans un détecteur (30) une valeur de seuil de courant représentatif du courant délivré par la pompe de charge (16) et en appliquant, en retour, une sortie logique du détecteur au circuit (31) de réinjection de charge.

## Claims

1. Phase locked loop for a voltage controlled oscillator (6), the loop comprising a phase comparator (3) receiving at its inputs (8, 9) a reference frequency and a frequency coming from the oscillator (6) and supplying logic values to command a charge pump (16), a charge re-injection circuit (31) receiving one of the inputs (8,9) of the comparator (3) and supplying a logic value to command the charge pump (16), the loop being **characterised in that** it additionally comprises a detector (30) of a threshold value of a current representative of the current supplied by the charge pump (16), a logic output of the detector (30) being applied on return to the charge re-injection circuit (31) in such a way that the duration of the charge re-injection is limited.

2. Loop according to Claim 1, **characterised in that** the charge re-injection circuit (31) comprises:
- a pulse generator (17) having an input (18), this input (18) constituting the input (18) of the re-injection circuit (31) and an output (19);
- a logic circuit (33) having two inputs (19, 32) and an output (34), one of the inputs (19) of the said logic circuit (33) being connected to the output (19) of the pulse generator (17), the other input (32) being connected to the output (34) of the said logic circuit (33) constituting the output (34) of the re-injection circuit (31).

3. Method of reducing a level of parasitic lines supplied by a voltage controlled oscillator (6) and controlled by a phase loop comprising a phase comparator (3) receiving at its inputs (8, 9) a reference frequency and a frequency coming from the oscillator (6) and supplying logic values to command a charge pump (16), a charge re-injection circuit (31) receiving one of the inputs (8, 9) of the comparator (3) and supplying a logic value to command the charge pump (16), the method being **characterised in that** the duration of the re-injection is limited by a threshold value of current, representative of the current supplied by the charge pump (16) being detected in a detector (30) and applying, in return, a logic output of the detector to the charge re-injection circuit (31).

## Patentansprüche

1. Phasenverriegelungsschleife eines spannungsgesteuerten Oszillators (6), wobei die Schleife einen Phasenkomparator (3), der als Eingang (8, 9) eine Referenzfrequenz und eine von dem Oszillator (6) stammende Frequenz erhält und logische Werte zur Steuerung einer Ladepumpe (16) liefert, und einen Ladungswiedereinspeisungs-Schaltkreis (31) umfasst, der einen der Eingänge (8, 9) des Komparators (3) erhält und einen logischen Wert zur Steuerung der Ladepumpe (16) liefert,
**dadurch gekennzeichnet, dass** sie außerdem einen Detektor (30) eines Schwellenwerts eines für den durch die Ladepumpe (16) gelieferten Strom repräsentativen Stroms umfasst und ein logischer Ausgang des Detektors (30) auf den Ladungswiedereinspeisungs-Schaltkreis (31) rückgekoppelt ist, um die Dauer der Ladungswiedereinspeisung zu begrenzen.

2. Schleife nach Anspruch 1, **dadurch gekennzeichnet, dass** der Ladungswiedereinspeisungs-Schaltkreis umfasst:
- einen Impulsgenerator (17) mit einem Eingang (18), wobei dieser Eingang (18) der Eingang (18) des Wiedereinspeisungs-Schaltkreises (31) ist, und einem Ausgang (19);
- einen Logikschaltkreis (33) mit zwei Eingängen (19, 32) und einem Ausgang (34), wobei einer der Eingänge (19) des genannten Logikschaltkreises (33) gekoppelt ist mit dem Ausgang (19) des Impulsgenerators (17), und der andere Eingang (32) gekoppelt ist mit dem Ausgang (34) des genannten Logikschaltkreises (33), der den Ausgang (34) des Wiedereinspeisungs-Schaltkreises (31) bildet.

3. Verfahren zur Reduzierung eines Pegels von Störlinien, geliefert durch einen Oszillator (6), der spannungsgesteuert ist und kontrolliert wird durch eine Phasenschleife, die einen Phasenkomparator, der als Eingang (8, 9) eine Referenzfrequenz und eine von dem Oszillator (6) stammende Frequenz erhält und logische Werte zur Steuerung einer Ladepumpe (16) liefert, und einen Ladungswiedereinspeisungs-Schaltkreis (31) umfasst, der einen der Eingänge (8, 9) des Komparators (3) erhält und einen logischen Wert zur Steuerung der Ladepumpe (16) liefert, wobei dieses Verfahren **dadurch gekennzeichnet ist, dass** man die Dauer der Wiedereinspeisung begrenzt, indem man in einem Detektor (30) einen Schwellenwert eines für den durch die Ladepumpe (16) gelieferten Strom repräsentativen Stroms detektiert und indem man einen logischen Ausgang des Detektors auf den Ladungswiedereinspeisungs-Schaltkreis (31) rückkoppelt.
